# EUROPÄISCHE PATENTSCHRIFT

(11) **EP 1 020 992 B1**
(45) Veröffentlichungstag und Bekanntmachung des Hinweises auf die Patenterteilung: **08.08.2007**
(21) Anmeldenummer: 99124192.8
(22) Anmeldetag: 03.12.1999
(51) Int. Cl.: H03J 1/00, H04H 1/00

(54) **Rundfunkempfänger und Verfahren zum Ändern von Einstellungen eines Rundfunkempfängers**
Radio receiver and method for changing the settings of a radio receiver
Récepteur de radio et méthode pour changer la configuration d' un récepteur de radio

(30) Priorität: 11.01.1999 DE 19900625
(43) Veröffentlichungstag der Anmeldung: 19.07.2000
(73) Patentinhaber: ROBERT BOSCH GMBH, 70442 Stuttgart (DE)
(72) Erfinder: Schmidt, Heinrich, 31199 Diekholzen (DE); Hoffmann, Ralf, 31137 Hildesheim (DE)

(56) Entgegenhaltungen:
- US-A- 5 584 051

## Beschreibung

Die Erfindung bezieht sich auf einen Rundfunkempfänger und ein Verfahren zum Ändern von Geräteeinstellungen oder Einstellungsdaten eines Rundfunkempfängers.

Bei der Einführung von neuen Standards für Rundfunkempfänger kommt es oftmals vor, daß bereits im Betrieb befindliche Rundfunkempfänger nicht alle neuen Funktionen umsetzen können. Somit sind Rundfunkempfänger beim Fortschritt der durch die Rundfunksignale möglichen Funktionen oftmals bereits nach kurzer Zeit wieder technisch veraltet. Dies führt dazu, daß die Rundfunkgeräte nur Grundfunktionen des Rundfunkempfängers ausführen können, und es bewirkt weiterhin eine Verlangsamung der technischen Entwicklung, da über die Rundkfunksignale übertragene neue Funktionen für die meisten Besitzer von Rundfunkempfängern uninteressant sind und somit oftmals auch wenig Interesse bei den Rundfunkanbietern besteht, diese neuen Funktionen anzubieten.

Der Erfindung liegt die Aufgabe zugrunde, gegenüber dem Stand der Technik Verbesserungen zu schaffen und insbesondere die Anwendung von neuen Funktionen bei Rundfunkempfängern zu gewährleisten.

Diese Aufgabe wird durch einen Rundfunkempfänger gelöst, der aufweist:
einen Empfangsteil zum Empfangen von Rundfunksignalen und Weiterleitungen von in den Rundfunksignalen enthaltenen gerätespezifischen Kennungssignalen zur Benennung eines Rundfunkempfängertyps und Steuersignalen zur Veränderung von Geräteeinstellungen des Rundfunkempfängers,
   eine Vergleichseinrichtung zum Vergleichen der empfangenen gerätespezifischen Kennungssignale mit voreingestellten gerätespezifischen Kenndaten und Ausgeben eines Freigabesignals bei Übereinstimmung der empfangenen gerätespezifischen Kennungssignale mit den voreingestellten gerätespezifischen Kenndaten, und
   eine Speichereinrichtung zum Speichern von Einstellungsdaten,
wobei bei Vorliegen eines Freigabesignals zumindest ein Teil der in der Speichereinrichtung gespeicherten Einstellungsdaten und/oder Geräteeinstellungen durch die aufgenommenen Steuersignale veränderbar ist.

Die Aufgabe wird weiterhin durch ein Verfahren zum Ändern von Einstellungsdaten und/oder Geräteeinstellungen eines Rundfunkempfängers gelöst, bei dem
ein Rundfunksender Funksignale aussendet, die gerätespezifische Kennungssignale zur Benennung eines Rundfunkempfängertyps und Steuersignale zur Veränderung von Einstellungsdaten und/oder Geräteeinstellungen des Rundfunkempfängers enthalten,
ein Rundfunkempfänger die gerätespezifischen Kennungssignale mit voreingestellten gerätespezifischen Kenndaten vergleicht und bei Übereinstimmung der empfangenen gerätespezifischen Kennungssignale mit seinen voreingestellten gerätespezifischen Kenndaten die Steuersignale aufnimmt und Einstellungsdaten und/oder Geräteeinstellungen in Abhängigkeit von den aufgenommenen Steuersignalen ändert.

Erfindungsmäßig kann somit der Rundfunkempfänger durch von einem Rundfunksender ausgesandte Funksignale aktualisiert werden. Hierdurch wird die Möglichkeit einer nachträglichen Einflußnahme auf die Geräteeinstellungen und gespeicherten Daten von Geräten geschaffen, so daß die Ausführung neuer Funktionen und die Anpassung an neue Standards vorgenommen werden kann, ohne daß die Geräte vom Benutzer entsprechend neu eingestellt werden müssen oder Teile der Rundfunkempfänger ausgetauscht werden müssen.

Eine nachträgliche Aktualisierung gespeicherter Daten ist zwar bei Computern und anderen Recheneinrichtungen bekannt. Hierbei werden Daten im allgemeinen über Datenträger wie Disketten oder CDs oder über eine Schnittstelle direkt bei einer speziell hierfür vorgesehenen Vorrichtung aktualisiert. Eine entsprechende Aktualisierung gespeicherter Daten bei Rundfunkempfänger wäre aber sehr aufwendig, da die Endgeräte in Fachbetriebe gebracht werden müßten und in den Geräten eine Schnittstelle für einen externen Zugriff vorgesehen sein müßte. Indem erfindungsgemäß eine Aktualisierung über den Rundfunkempfang ermöglicht wird, kann die in dem Radioempfänger bereits für den Rundfunkempfang vorgesehene Empfangseinrichtung als derartige Schnittstelle verwendet werden. Erfindungsgemäß wird insbesondere auch ermöglicht, daß eine Aktualisierung der Daten über Rundfunkprogramme ermöglicht wird, so daß keine zusätzlichen Sendeeinrichtung zur Aktualisierung älterer Rundfunkgeräte verwendet werden müßen. Eine derartige Aktualisierung der Geräteeinstellungen über die Rundfunkstation kann insbesondere bei Rundfunkempfängern nach RDS- (Radiodatensystem) Norm erreicht werden, indem der offene Datenkanal (open data channel, ODC) für die Übertragung der gerätespezifischen Kennzeichnungssignale verwendet wird.

Erfindungsgemäß werden über die Rundfunksignale gerätespezifische Kennungssignale und Steuersignale übermittelt. Indem die gerätespezifischen Kennungssignale zur Identifizierung eines Gerätetyps verwendet werden, können Aktualisierungsdaten für verschiedene Gerätetypen über einen Rundfunksender übertragen werden, ohne daß ein Rundfunkempfänger falsche Aktualisierungsdaten aufnimmt.

Die Steuerdaten können dabei Auswerteroutinen auslösen, die bereits in den Radioempfängern vorinstalliert sind. Somit kann die Datenmenge, die für eine Aktualisierung über die Rundfunksignale übertragen werden muß, begrenzt sein. Insbesondere können auch verschiedene Parametereinstellungen bereits vorinstalliert sein, so daß eine Auswahl zwischen verschieden alternativen Einstellungen, im einfachsten Fall die Einstellung "Funktion an" bzw. "Funktion aus" durch ein einfaches Signal aktiviert werden kann. Es ist jedoch auch die Übertragung größerer Datensätze möglich, die ältere, in den Rundfunkempfängern gespeicherte Daten direkt überschreiben.

Die Erfindung wird im folgenden anhand der beiliegenden Zeichnungen an einigen Ausführungsformen näher erläutert. Es zeigen:
- Figur 1 -: den Aufbau eines erfindungsgemäßen Rundfunkempfängers, und
- Figur 2 -: ein Diagramm eines erfindungsgemäßen Verfahrens einer Parameter-Aktualisierung.

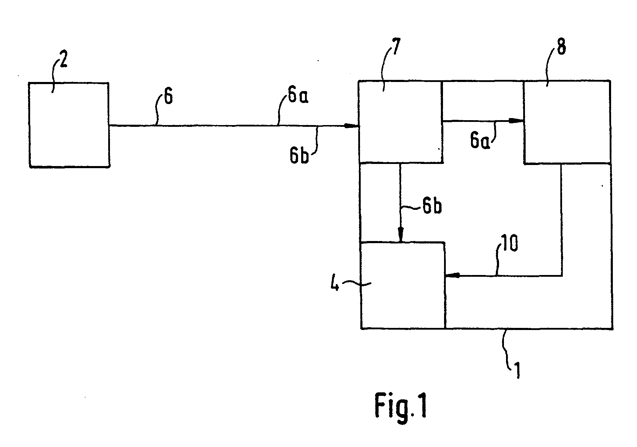

Ein Sender 2 sendet gemäß Figur 1 Rundfunksignale 6 aus. Die Rundfunksignale 6 enthalten gerätespezifische Kennungssignale 6a und Steuersignale 6b. Die Rundfunksignale 6 werden wie durch den Pfeil angedeutet von einem Rundfunkempfänger 1 aufgenommen, der z.B. ein tragbares Radio oder ein Autoradio sein kann.

Der Radioempfänger 1 weist einen Empfangsteil 7 auf, der die Rundfunksignale 6 aufnimmt und dies in den Rundfunksignalen enthaltene Kennungssignale 6a zur Kennzeichnung eines Gerätetyps und Steuersignale 6b weitergibt. Die Kennungsignale 6a werden in einer Vergleichseinrichtung 8 mit voreingestellten gerätespezifischen Kennungssdaten verglichen. Bei Übereinstimmung der empfangenen Kennungssignale 6a und der voreingestellten gerätespezifischen Kennungsdaten wird ein Freigabesignal 10 an eine Speichereinheit 4 ausgegeben. Die von einem Rundfunksender ausgesendeten Kennungssignale 6a können dabei grundsätzlich mit mehreren verschiedenen gerätespezifischen Kennungsdaten übereinstimmen, wenn eine Aktualisierung für mehrere Gerätetypen erwünscht ist. Somit muß im allgemeinen keine Identität zwischen den empfangenen Kennungssignalen und den gerätespezifischen Kennungsdaten vorliegen, um ein Freigabesignal 10 auszugeben.

Die Speichereinheit 4 nimmt bei Vorliegen des Freigabesignals 10 die Steuersignale 6b vom Empfangsteil 7 auf. Die Steuersignale 6b können dabei in der Speicherinheit 4 direkt aufgenommen und abgespeichert werden. Weiterhin ist es jedoch auch möglich, daß die Steuersignale 6b Auswerteroutinen in der Speicheinheit 4 auslösen, die bestimmte alternative Geräteeinstellungen oder Funktionseinstellungen auslösen oder aktivieren bzw. deaktivieren.

Dabei ist neben dem Aktivieren und Deaktivieren voreingetellter Funktionen auch die Aktualisierung von Parametern und Texten durch derartige Auswerteroutinen möglich.

Erfindungsgemäß kann insbesondere ein Radiodatensystem, z.B. nach der RDS-Norm EN 50067 verwendet werden, bei dem Daten in zweiunddreißig Datengruppen, O A - 15 A und O B - 15 B übertragen werden, wobei jede Datengruppe vier Blöcke A, B, C, D aufweist. Da in einem RDS-System nur eine relativ geringe Kapazität für eine Datenübertragung vorhanden ist, ist eine Implementierung von alternativen Funktionen in dem Gerät vorteilhaft. Bei einem derartigen RDS-System können die Kennnungssignale über den offenen Datenkanal (open data-channel, ODC) übertragen werden. Vorteilhafterweise kann ein Aktualisierungskanal bzw. "update channel" eingerichtet werden. Hierfür können vorteilhafterweise für verschiedene Geräte Anwendungs-Identifizierer (AID) bereitgestellt werden, die beispielsweise bei der europäischen Boadcast Union (EBU) reserviert werden können. Ein derartiger Anwendungs-Identifizierer kann als 16-bit-Ziffer zur eindeutigen Identifizierung des Aktualisierungskanal dienen. Nach der RDS-Norm kann in einer 3 A-Gruppe des RDS-Systems diese AID als Block D übertragen werden, um einem Radioempfänger die Verfügbarkeit des Aktualisierungskanals zu signalisieren. Im Block C dieser 3 A-Gruppe findet der Runkfunkempfänger die Information, für welches Modell und welche Version zur Zeit eine Aktualisierung bzw. ein update angeboten wird. Falls es sich bei dem Endgerät um ein solches Modell handelt, kann dieses im Block B der 3 A-Gruppe den Gruppentyp, z.B. 9 A, erkennen, in dem der Aktualisierungskanal auf dieser Frequenz geöffnet ist.

Das Radioendgerät 1 wird nun derartige Daten, z.B. 9 A-Gruppen sammeln. In jeder dieser Gruppen stehen nach der RDS-Norm für den Aktualisierungskanal 37 bit zur Verfügung. In den vier Blöcken der 9 A-Gruppe können diese 37 Bits so aufgeteilt werden, daß z.B. die im Block B befindlichen ersten 5 Bit anzeigen, welcher Funktion die jeweilige Gruppe angehört. Dies kann z.B. eine reine Softwareaktualisierung bzw. Softwareupdate sein, eine Parameteraktualisierung, eine Frequenzlisteninitialisierung, eine Funktionsaktivierung, bzw. Funktionsdeaktivierung usw.

Hierbei kann beispielsweise ein Signal übertragen werden, daß das von den Rundfunksendern übertragene Uhrzeitsignal (clock-time,CT) zwar für Anzeigezwecke verwendet werden soll, aber nicht für den Verkehrsmeldekanäl (traffic message channel, tmc), um Meldungen mit falschen Inhalt zu vermeiden. Für eine CT-Aktivierung muß demnach ein Hinweis auf eine Aktivierung einer Funktion vorhanden sein, die in dem 5-Bit-Block B als Funktionaktivierungssignal übertragen wird. Der Block B dient somit lediglich der Anzeige, ob eine Funktion aktiviert oder deaktiviert werden soll. Die genaue Bezeichnung der zu aktivierenden bzw. deaktivierenden Funktion kann beispielsweise in Block C der 9 A-Gruppe in Form einer 16-Bit-Nummer angegeben sein. Die verschiedenen Zustände der Funktion können beispielsweise im Block D gespeichert sein und im einfachsten Fall für binäre Zustände (ein/aus) darstellen. Im Beispiel der CT-Einstellung wird somit im Block C die Funktionalität der CT-Auswertung kodiert sein, im Block D der Zustand "aktiv".

Somit kann der Rundfunkempfänger nun die CT-Funktion aktivieren und die nach RDS-Norm in der Gruppe 4 A enthaltene Zeitinformation nicht nur für Anzeigezwecke sammeln, sondern auch für TMC-Zeitangaben auswerten.

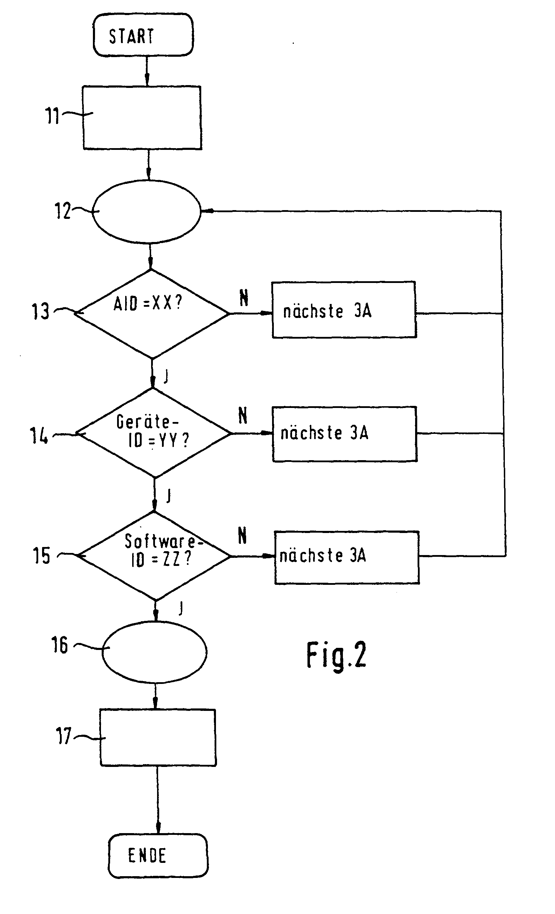

Figur 2 zeigt ein Beispiel, wie eine derartige Parameter-Aktualisierung bzw. Funktions-Aktualisierung vorgenommen werden kann. Hierbei kann eine Aktualisierung für bestimmte GeräteTypen und Software-Versionen dieser Gerät-Typen vorgenommen werden. Eine entsprechende Auswerteroutine wird bei Schritt 11 gestartet. Bei 12 werden anschließend 3A-Gruppen, die auf der Frequenz übertragen werden, gesammelt. Die gesammelten 3A-Gruppen werden gemäß 13 dahingehend überprüft, ob in ihrem Block D die AID übertragen wird. Wird diese AID übertragen, so kann gemäß Block 14 überprüft werden, ob die geräteeigene Geräte-ID mit der in Block C dieser 3A-Gruppe angegebenen Geräte-ID übereinstimmt. Falls dies zutrifft, kann in Schritt 15 gegebenenfalls noch die jeweilige Software-Version mit der Software-ID verglichen werden, die in Block C dieser 3A-Gruppe übertragen wird. Trifft eine dieser Bedingungen nicht zu, wird die aufgenommene 3A-Gruppe nicht weiter verwendet und die nächste 3A-Gruppe auf dieser Bedingung hin untersucht. Treffen die angegebenen Bedingungen zu, kann in Block B der 3A-Gruppe der Gruppentyp, zum Beispiel 9A, entnommen und können gemäß Schritt 16 derartige 9A-Gruppen des offenen Datenkanals gesammelt werden. Gemäß Schritt 17 können anschließend die Aktualisierungen gemäß den übertragenen Daten durchgeführt werden.

Die von einem Sender 2 übertragenen gerätespezifischen Kennnungssignale 6a und Steuersignale 6b können dem Sender von dem Gerätehersteller übermittelt werden, der auf diese Weise eine Aktualisierung der von ihm bereits verkauften Rundfunkendgeräte 1 vornehmen kann. Die Aktualisierung kann auch über Funksignale z.B. im kurzreichweitigen UKW-Bereich vorgenommen werden, so daß der Besitzer z.B. eines Autoradios nur in die Nähe eines derartigen Senders fahren muß, der beispielsweise in einer Werkstatt stehen kann, so daß automatisch eine Aktualisierung der Radiodaten vorgenommen wird.

## Patentansprüche

1. Rundfunkempfänger, mit
einem Empfangsteil (7) zum Empfangen von Rundfunksignalen (6) und Weiterleitungen von in den Rundfunksignalen enthaltenen gerätespezifischen Kennungssignalen (6a) zur Benennung eines Rundfunkempfängertyps und Steuersignalen (6b) zur Veränderung von Geräteeinstellungen des Rundfunkempfängers,
einer Vergleichseinrichtung (8) zum Vergleichen der empfangenen gerätespezifischen Kennungssignale (6a) mit voreingestellten gerätespezifischen Kenndaten und Ausgeben eines Freigabesignals (10) bei Übereinstimmung der empfangenen gerätespezifischen Kennungssignale mit den voreingestellten gerätespezifischen Kenndaten, und
einer Speichereinrichtung (9) zum Speichern von Einstellungsdaten,
wobei bei Vorliegen eines Freigabesignals (10) zumindest ein Teil der in der Speichereinrichtung (9) gespeicherten Einstellungsdaten und/oder Geräteeinstellungen durch die aufgenommenen Steuersignale (6b) veränderbar ist.

2. Rundfunkempfänger nach Anspruch 1, **dadurch gekennzeichnet, daß** bei Vorliegen eines Freigabesignals (10) in dem Steuersignal (6b) enthaltene Einstellungsdaten Speichereinrichtung (9) gespeichert werden.

3. Rundfunkempfänger nach Anspruch 2, **dadurch gekennzeichnet, daß** durch die Einstellungsdaten des empfangenen Steuersignals (6b) in der Speichereinrichtung (4) gespeicherte Einstellungsdaten ersetzt werden.

4. Rundfunkempfänger nach einem der Ansprüche 1 bis 3, **dadurch gekennzeichnet, daß** er voreingestellte Auswerteroutinen aufweist und bei Vorliegen eines Freigabesignals (10) eine oder mehrere Auswerteroutine(n) Einstellungsdaten von Geräteeinstellungen des Rundfunkempfängers ändern.

5. Rundfunkempfänger nach Anspruch 4, **dadurch gekennzeichnet, daß** mehrere alternative Geräteeinstellungen einstellbar sind, von denen jeweils eine Geräteeinstellung aktuell gesetzt ist, und in Abhängigkeit von dem empfangenen Steuersignal eine der alternativen Geräteeinstellung setzbar ist.

6. Rundfunkempfänger nach einem der Ansprüche 1 bis 5, **dadurch gekennzeichnet, daß** er ein Radiodatensystem (RDS) - Radioempfänger (2) ist und die gerätespezifischen Kennungssignale (6a) über einen offenen Daten-Kanal (ODC) übertragbar sind.

7. Rundfunkempfänger nach Anspruch 6, **dadurch gekennzeichnet, daß** die gerätespezifischen Kennungsdaten eine Anwendungs-Identifizierung (AID) enthalten, die in einer 3 A-Gruppe des Rundfunksignals, vorzugsweise in Block D der 3 A-Gruppe, übertragbar sind.

8. Rundfunkempfänger nach einem der Ansprüche 1 bis 7, **dadurch gekennzeichnet, daß** durch die Steuersignale (6b) eine Parameteraktualisierung und/oder Frequenzlisteninitialisierung und/oder Funktionsaktivierung bzw. Funktionsdeaktivierung auslösbar ist.

9. Rundfunkempfänger nach einem der Ansprüche 1 bis 8, **dadurch gekennzeichnet, daß** ein Steuersignal (6b) ein Funktionskennzeichnungsignal zur Kennzeichnung einer Funktion und ein Funktionsaktivierungssignal zur Aktivierung bzw. Deaktivierung der Funktion enthält.

10. Verfahren zum Ändern von Geräteeinstellungen und/oder Einstellungsdaten eines Rundfunkempfängers (1), insbesondere eines Rundfunkempfängers nach einem der Ansprüche 1 bis 9, bei dem
ein Rundfunksender (2) Rundfunksignale (6) aussendet, die gerätespezifische Kennungssignale (6a) zur Benennung eines Rundfunkempfängertyps und Steuersignale (6b) zur Veränderung von Einstellungsdaten und/oder Geräteeinstellungen des Rundfunkempfängers (1) enthalten,
ein Rundfunkempfänger (1) die gerätespezifischen Kennungssignale (6a) mit voreingestellten gerätespezifischen Kenndaten vergleicht und bei Übereinstimmung der empfangenen gerätespezifischen Kennungssignale (6a) mit seinen voreingestellten gerätespezifischen Kenndaten die Steuersignale (6b) aufnimmt und Einstellungsdaten und/oder Geräteeinstellungen in Abhängigkeit von den aufgenommenen Steuersignalen ändert.

## Claims

1. Broadcast radio receiver, having
a reception part (7) for receiving broadcast radio signals (6) and instances of forwarding of appliance-specific identification signals (6a) contained in the broadcast radio signals for the purpose of designating a broadcast radio receiver type and control signals (6b) for altering appliance settings in the broadcast radio receiver,
a comparison device (8) for comparing the received appliance-specific identification signals (6a) with preset appliance-specific characteristic data and outputting an enable signal (10) if there is a match between the received appliance-specific identification signals and the preset appliance-specific characteristic data, and
a memory device (9) for storing settings data,
where the presence of an enable signal (10) allows at least some of the settings data and/or appliance settings stored in the memory device (9) to be altered by the control signals (6b) picked up.

2. Broadcast radio receiver according to Claim 1, **characterized in that** the presence of an enable signal (10) prompts settings data contained in the control signal (6b) to be stored in the memory device (9).

3. Broadcast radio receiver according to Claim 2, **characterized in that** the settings data in a received control signal (6b) replace settings data stored in the memory device (4).

4. Broadcast radio receiver according to one of Claims 1 to 3, **characterized in that** it has preset evaluation routines, and the presence of an enable signal (10) prompts one or more evaluation routine(s) to change settings data from appliance settings in the broadcast radio receiver.

5. Broadcast radio receiver according to Claim 4, **characterized in that** a plurality of alternative appliance settings can be set, among which one respective appliance setting is currently set, and one of the alternative appliance settings can be set on the basis of the received control signal.

6. Broadcast radio receiver according to one of Claims 1 to 5, **characterized in that** it is a radio data system (RDS) radio receiver (2), and the appliance-specific identification signals (6a) can be transmitted via an open data channel (ODC).

7. Broadcast radio receiver according to Claim 6, **characterized in that** the appliance-specific identification data contain an application identification (AID) which can be transmitted in a 3A group for the broadcast radio signal, preferably in block D of the 3A group.

8. Broadcast radio receiver according to one of Claims 1 to 7, **characterized in that** the control signals (6b) can initiate a parameter update and/or frequency list initialization and/or function activation and function deactivation.

9. Broadcast radio receiver according to one of Claims 1 to 8, **characterized in that** a control signal (6b) contains a function characterization signal for characterizing a function and a function activation signal for activating and deactivating the function.

10. Method for changing appliance settings and/or settings data in a broadcast radio receiver (1), particularly a broadcast radio receiver according to one of Claims 1 to 9, in which
a broadcast radio transmitter (2) emits broadcast radio signals (6) which contain appliance-specific identification signals (6a) for designating a broadcast radio receiver type and control signals (6b) for altering settings data and/or appliance settings in the broadcast radio receiver (1),
a broadcast radio receiver (1) compares the appliance-specific identification signals (6a) with preset appliance-specific characteristic data and, if there is a match between the received appliance-specific identification signals (6a) and its preset appliance-specific characteristic data, picks up the control signals (6b) and changes settings data and/or appliance settings on the basis of the control signals picked up.

## Revendications

1. °) Récepteur radio comportant :
une partie de réception (7) pour recevoir des signaux radio (6), et retransmettre des signaux d'identification (6a) spécifiques de l'appareil et contenus dans les signaux radio pour désigner un type de récepteur radio, et des signaux de commande (6b) permettant de modifier les paramètres du récepteur radio,
un dispositif de comparaison (8) pour comparer les signaux d'identification spécifiques de l'appareil (6a) reçus à des données caractéristiques spécifiques de l'appareil présélectionnées, et émettre un signal de validation (10) en cas de concordance des signaux d'identification spécifiques de l'appareil reçus avec les données caractéristiques spécifiques de l'appareil réglées, et
un dispositif de mémorisation (9) pour mémoriser les données paramétrées,
dans lequel, en présence d'un signal de validation (10), au moins une partie des données paramétrées et/ou des paramètres de l'appareil mémorisés dans le dispositif de mémorisation (9) peut être modifiée par les signaux de commande (6b) enregistrés.

2. °) Récepteur radio selon la revendication 1,
**caractérisé en ce qu'**
en présence d'un signal de validation (10), des données paramétrées contenues dans le signal de commande (6b) sont mémorisées dans le dispositif de mémorisation (9).

3. °) Récepteur radio selon la revendication 2,
**caractérisé en ce que**
des données paramétrées mémorisées dans le dispositif de mémorisation (4) sont remplacées par des données paramétrées du signal de commande (6b) reçu.

4. °) Récepteur radio selon l'une quelconque des revendications 1 à 3,
**caractérisé en ce qu'**
il présente des routines d'analyse présélectionnées et en présence d'un signal de validation (10), une ou plusieurs routines d'analyse modifient des données paramétrées des paramètres du récepteur radio.

5. °) Récepteur radio selon la revendication 4,
**caractérisé en ce qu'**
on peut régler plusieurs paramètres alternatifs de l'appareil dont un est actuellement activé, et l'un des paramètres alternatifs peut être activé en fonction du signal de commande reçu.

6. °) Récepteur radio selon l'une quelconque des revendications 1 à 5,
**caractérisé en ce qu'**
il s'agit d'un récepteur radio (2) à système de radio par données (RDS) et les signaux d'identification spécifiques de l'appareil (6a) peuvent être transmis par l'intermédiaire d'un canal de données ouvert (ODC).

7. °) Récepteur radio selon la revendication 6,
**caractérisé en ce que**
les données d'identification spécifiques de l'appareil contiennent une identification d'utilisation (AID) qui peut être transmise dans un groupe 3A du signal radio, de préférence dans le bloc D du groupe 3A.

8. °) Récepteur radio selon l'une quelconque des revendications 1 à 7,
**caractérisé en ce que**
les signaux de commande (6b) peuvent déclencher une actualisation des paramètres et/ou une initialisation de la liste des fréquences et/ou une activation respectivement une désactivation des fonctions.

9. °) Récepteur radio selon l'une quelconque des revendications 1 à 8,
**caractérisé en ce qu'**
un signal de commande (6b) contient un signal d'identification d'une fonction pour identifier une fonction et un signal d'activation d'une fonction pour activer respectivement désactiver une fonction.

10. °) Procédé pour modifier des paramètres et/ou des données paramétrées d'un récepteur radio (1), en particulier d'un récepteur radio selon l'une quelconque des revendications 1 à 9,
selon lequel
un émetteur radio (2) émet des signaux radio (6) qui contiennent des signaux d'identification spécifiques de l'appareil (6a) pour désigner un type de récepteur radio et des signaux de commande (6b) pour modifier des données paramétrées et/ou des paramètres du récepteur radio (1),
un récepteur radio (1) compare les signaux d'identification spécifiques de l'appareil (6a) aux données caractéristiques spécifiques de l'appareil présélectionnées et, en cas de concordance entre les signaux d'identification spécifiques de l'appareil (6a) reçus et ses données caractéristiques spécifiques de l'appareil présélectionnées, enregistre les signaux de commande (6b) et modifie les données paramétrées et/ou les paramètres de l'appareil en fonction des signaux de commande enregistrés.
